Europäisches Patentamt

European Patent Office

Office européen des brevets

(19)

(11) Veröffentlichungsnummer: **0 217 163**
**B1**

(12) **EUROPÄISCHE PATENTSCHRIFT**

(45) Veröffentlichungstag der Patentschrift:
27.12.89

(51) Int. Cl.⁴: **H05K 7/14, H05K 7/18**

(21) Anmeldenummer: 86112161.4

(22) Anmeldetag: 02.09.86

(54) Einrichtung zur Montage und Halterung elektrischer Inneneinbauten.

(30) Priorität: 05.09.85 DE 3531718

(43) Veröffentlichungstag der Anmeldung:
08.04.87 Patentblatt 87/15

(45) Bekanntmachung des Hinweises auf die Patenterteilung:
27.12.89 Patentblatt 89/52

(84) Benannte Vertragsstaaten:
CH DE FR GB IT LI NL

(56) Entgegenhaltungen:
EP-A- 0 105 150
DE-A- 2 514 048
DE-A- 3 110 717
DE-B- 1 282 758
DE-B- 2 119 709

(73) Patentinhaber: **Siemens Aktiengesellschaft,
Wittelsbacherplatz 2, D-8000 München 2(DE)**
Patentinhaber: **ANT Nachrichtentechnik GmbH,
Gerberstrasse 33, D-7150 Backnang(DE)**

(72) Erfinder: **Riedl, Friedrich, Dipl.-Ing. (FH),
Herbststrasse 15, D-8035 Gauting(DE)**
Erfinder: **Mayer, Franz, Wastl-Witt-Strasse 11,
D-8000 München 21(DE)**
Erfinder: **Neumann, Dieter, Dipl.-Ing. (FH),
Kardinal-Wendel-Strasse 58,
D-8190 Wolfratshausen(DE)**
Erfinder: **Hirsch, Gerhard, Ing. grad., Häfnersweg 66,
D-7150 Backnang(DE)**
Erfinder: **Stephan, Roland, Ing. grad.,
Glasäckerstrasse 33, D-7151 Allmersbach I.T.(DE)**
Erfinder: **Hohloch, Manfred, Trailhöferstrasse 86,
D-7151 Auenwald(DE)**
Erfinder: **Latsch, Wolfgang, Dipl.-Ing. (FH),
Hermann-Hesse-Weg 2, D-7151 Auenwald(DE)**

(74) Vertreter: **Mehl, Ernst, Dipl.-Ing. et al, Postfach 22 13 17,
D-8000 München 22(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Einrichtung zur Montage und Halterung elektrischer Inneneinbauten, wie z.B. Leiterplatten, Steckbaugruppen oder Einschübe, mit einer Profil-Trägerplatte, die mit zu zwei einander parallel gegenüberliegenden Plattenrändern parallelen Nuten und Profilrippen für Führungsschienen und mindestens eine Rasterschiene der Inneneinbauten ausgebildet ist, insbesondere für Gehäuse elektrischer Geräte. Eine derartige Einrichtung geht aus der DE-OS 31 1O 717 als bekannt hervor.

Es ist seit langem üblich, Träger für einschiebbar oder einsteckbar ausgebildete elektrische Inneneinbauten, wie Leiterplatten, Steckbaugruppen oder Einschübe, mit entsprechenden Aufnahmeeinrichtungen auszubilden. Aus der DE-AS 1 119 92O ist ein Träger zur Aufnahme von Einschüben mit Bauelementen bekannt, bei dem Führungsschienen für die Einschübe in Rasterschienen eingehakt und befestigt sind. Hierbei ist jedoch eine aufwendige Ausgestaltung der Führungs- und Rasterschienen vorgesehen. Eine ähnlich aufgebaute Geräteeinheit zur Aufnahme von Steckbaugruppen ist aus der DE-PS 1 271 793 bekannt. Hierbei ist das Teilungsraster für die aus elastischem Kunststoff bestehenden Führungsschienen durch zwei Schlitzreihen gebildet, welche in zwei einander gegenüberliegenden, als profilierte Aufnahmebleche ausgebildete Begrenzungswände der Geräteeinheit vorgesehen sind. Bei dieser Geräteeinheit sind also Boden- und Deckplatte mit Schlitzreihen ausgebildet, wobei zur Versteifung der Gehäusewände Zwischenwände vorgesehen sind, die in die Schlitzreihen ähnlich wie die Führungsschienen einsetzbar sind. Bei den bekannten Trägern sind in der eingehakten Stellung der Führungsschienen auch die den Einschüben oder Steckbaugruppen zugeordneten Federleisten gegen den Träger verklemmend gehalten, jedoch keine Mittel für die Verdrahtung der Einschübe oder Steckbaugruppen untereinander vorgesehen und in deren Führungs- und Montagesystem mit einbezogen. Außerdem sind die bekannten Träger mehr für den Einbau in Gestelle oder Schränke vorgesehen, aber nicht für den Aufbau von mechanisch stabilen, dichten Gehäusen geeignet. Dies gilt auch für die aus der DE-AS 21 19 7O9 und der DE-OS 25 14 O48 bekannten Träger für elektrische Baugruppen oder Leiterplatten, die ebenfalls mit Führungs- und Rasterschienen als Aufnahmeeinrichtungen ausgebildet sind. Darüberhinaus ist bei diesen bekannten Trägern zur Verdrahtung der Baugruppen oder Leiterplatten untereinander eine mit Steckerleisten versehene Verdrahtungsplatte vorgesehen, wobei zur Befestigung dieser Verdrahtungsplatte am Träger an dem betreffenden Ende der Führungsschienen Rastverbindungselemente vorgesehen sind, die in entsprechenden Aussparungen der Verdrahtungsplatte eingreifen. Die Verdrahtungsplatte ist hier also in das Führungs- und Montagesystem der Baugruppen oder Leiterplatten mit einbezogen. Abgesehen davon, daß die bekannten Träger aber einen für den Aufbau von mechanisch stabilen, dichten Gehäusen ungeeigneten und auch nicht vorgesehenen Aufbau haben, bietet auch das Führungs- und Montagesystem für die Baugruppen oder Leiterplatten keine ausreichend einfachen Möglichkeiten zur Montage sowie zum Nachrüsten oder Auswechseln einzelner Teile dieses Systems.

Schließlich ist aus der DE-OS 31 1O 717 ein weiterer Baugruppenträger mit Führungsleisten und zwei Rastschienen für Leiterplatten bekannt, der aus einer relativ dünnen Profil-Trägerplatte mit unregelmäßigem, unterschiedlichem Profilverlauf besteht, wobei die Rastschienen in die Profilierung eingesetzt und dort schraubenlos durch Rastnasen der danach in die Profilierung einzusetzenden Führungsleisten gehalten sind. Dieser bekannte Baugruppenträger weist aber keine Mittel zur Verdrahtung für die Leiterplatten untereinander auf und setzt eine Anordnung der Rastschienen unter den Führungsleisten in dem die Baugruppen aufnehmenden Bereich voraus. Außerdem ist der bekannte Träger für den Aufbau von Gehäusen ebenfalls weniger gut geeignet.

Der Erfindung liegt daher die Aufgabe zugrunde, eine sowohl für einen Einzelträger als auch zum Aufbau von Gehäusen geeignete Einrichtung zur Montage und Halterung elektrischer Inneneinbauten zu schaffen, bei der alle für die Inneneinbauten vorgesehenen Komponenten, wie Rast-, Führungs- und Verdrahtungsmittel so ausgebildet sind und zusammenwirken, daß ein als Ganzes, ohne Einsatz von Werkzeugen lediglich durch Einschnappen oder Einrasten auf einem Träger zu befestigendes System bei einfachen Montage-, Nachrüstungs- und Auswechslungsmöglichkeiten aller Komponenten entsteht.

Diese Aufgabe wid bei einer Einrichtung der eingangs genannten Art gemäß der Erfindung durch die Kombination folgender Merkmale gelöst:

a) die Profilrippen der Trägerplatte sind in gleichem Abstand voneinander angeordnet und bestehen aus einem zur Plattenebene senkrechten Steg und einer auf dem Steg liegend angeordneten, über beide senkrechte Seiten des Steges hinausragenden C-Profilschiene mit einer zu den Inneneinbauten hin offenen T-Nut,

b) außerhalb des die Inneneinbauten aufnehmenden Bereiches der Trägerplatte ist zwischen den beiden äußersten Profilrippen und dem jeweiligen Rand der Trägerplatte eine zu den Inneneinbauten hin offene T-Nut vorgesehen,

c) in die eine am Plattenrand vorgesehene T-Nut ist eine mit einem Teilungsraster ausgebildete Rasterschiene U-förmigen Querschnitts selbstklemmend eingesetzt,

d) in die andere am gegenüberliegewnden Plattenrand vorgesehene T-Nut ist senkrecht zur Plattenebene und zur Einschubrichtung der Inneneinbauten eine gemeinsame Verdrahtungsplatte eingesetzt, die mit im Teilungsraster der Rasterschiene angeordneten Aussparungen ausgebildet ist,

e) die aus elastischem Kunststoff bestehenden Führungsschienen liegen auf den C-Profilschienen auf und sind an ihrer der Trägerplatte zugekehrten Unterseite mit mindestens zwei Einschnapphaken ausgebildet und in die C-Profilschienen eingerastet,

f) die Führungsschienen sind an beiden Enden jeweils mit einem in Richtung auf die Trägerplatte gerichteten Zentrierhaken ausgebildet und damit in das Teilungsraster der Rasterschiene bzw. in die Aussparungen der gemeinsamen Verdrahtungsplatte eingehängt, so daß dadurch die Führungsschienen seitlich im Teilungsraster fixiert sind und die Verdrahtungsplatte in der T-Nut gehalten ist.

Bei einer derartigen Einrichtung sind alle für die Montage, Halterung und Verdrahtung der Inneneinbauten vorgesehenen Komponenten lediglich durch Einschnappen, Ein- oder Verrasten in der Profilierung der Trägerplatte in dieser fixierbar, und zwar so, daß variable, also örtlich veränderbare Befestigungsmöglichkeiten für die Inneneinbauten gegeben sind. Damit ist ein Montage- und Halterungssystem geschaffen, dessen einzelne Komponenten so zusammenwirken, daß das gesamte System ohne Werkzeugeinsatz montierbar ist. Demzufolge ist die Montage der einzelnen Komponenten sowie deren Auswechslung oder Nachrüstung in einfacher Weise durchführbar und das gesamte System in Teilpartien durch Ein- und Ausrasten einzelner Komponenten veränderbar. Dabei ist es besonders vorteilhaft, daß die in das Führungs- und Montagesystem für die Inneneinbauten mit einbezogene Verdrahtungsplatte ohne Demontage der Führungsschienen entfernbar ist, indem einfach die entsprechenden Zentrierhaken der Führungsschienen durch Verändern der Verdrahtungsplattenposition aus der Platte ausgerastet werden. Über das die vorteilhaften Eigenschaften des Führungs- und Montagesystems ergebende Zusammenwirken der einzelnen Komponenten hinaus hat die erfindungsgemäße Einrichtung auch noch den Vorteil, daß sie infolge der zweckmäßigen Ausbildung der Profil-Trägerplatte sowohl als Einzelträger als auch zum Aufbau von Gehäusen geeignet ist, wobei durch die vorgesehene Profilierung bei möglichst geringem Gewicht eine hohe Formstabilität erreicht wird. Außerdem ist die Profilierung der Trägerplatte auch im Hinblick auf eine möglichst wirkungsvolle Ableitung der von den eletrischen Bauelementen der Inneneinbauten erzeugten Verlustwärme von besonderen Vorteil, da sich durch die Profilform für die Wärmeableitung günstige Flächen sowie sehr große Oberflächen für eine gute Wärmeabsorption ergeben. Damit erfüllt die erfindungsgemäße Einrichtung gleichzeitig alle der in der Praxis gestellten vielfältigen Anforderungen in konstruktiv einfacher und besonders vorteilhafter Weise.

Vorteilhafte Ausgestaltungen der einzelnen Komponenten der erfindungsgemäßen Einrichtung sowie Weiterbildungen des Gegenstandes des Patentanspruchs 1 sind in den Unteransprüchen angegeben.

Die Erfindung ist im folgenden anhand eines in der Zeichnung dargestellten Ausführungsbeispiels der Einrichtung und der Anwendung einer solchen Einrichtung beim Aufbau eines Gehäuses für elektrische Geräte näher beschrieben.

Es zeigen

Fig. 1 ein Gehäuse für elektrische Geräte im Querschnitt und im geöffneten Zustand, d.h. ohne Frontplatte und ohne Rückwand,

Fig. 2 eine Ansicht in Richtung A einer zum Aufbau des Gehäuses verwendeten Profil-Trägerplatte mit einem Montage-, Führungs- und Halterungssystem für die Inneneinbauten des Gehäuses.

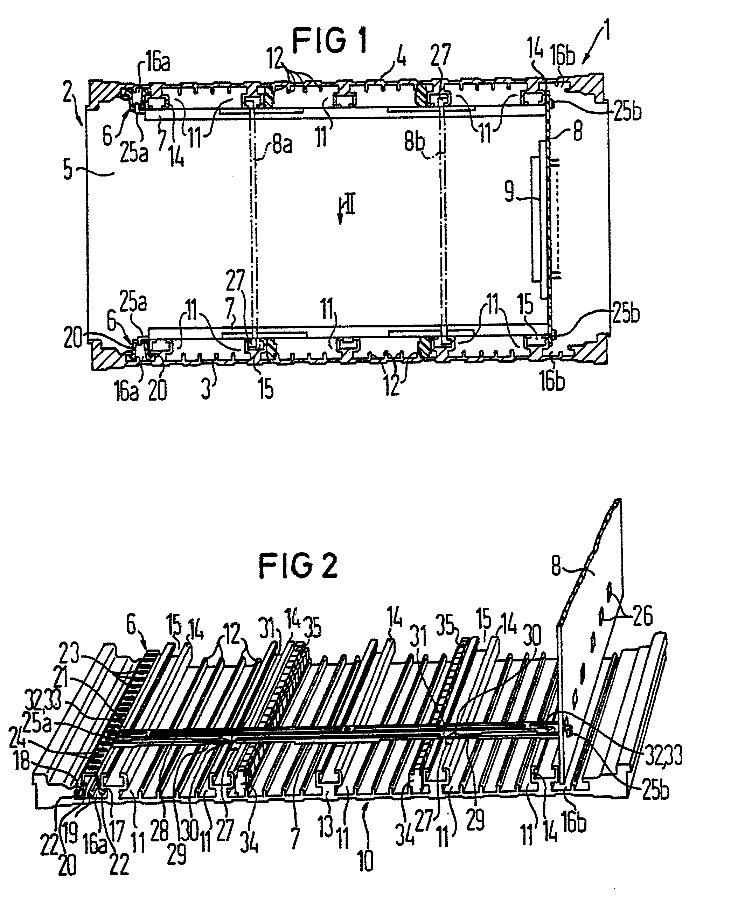

Das Gehäuse 1 in Fig. 1 hat einen kastenförmigen Rahmen oder Mantel 2, der aus zwei einander gegenüberliegenden Mittelteilen, nämlich einer Bodenplatte 3 und einer Deckplatte 4, sowie aus zwei damit dicht verbundenen Seitenwänden, von denen in Fig.1 nur die Seitenwand 5 zu sehen ist, besteht. An den beiden offenen Seiten ist der Gehäusemantel mit einer abschraubbaren oder abklappbaren Frontplatte und einer Rückwand, die beide nicht dargestellt sind, dicht verschließbar. Dabei kann die Wasser- und HF-Dichtigkeit des Gehäuses dadurch gewährleistet werden, daß die Mittelteile und die Seitenwände an den vier Kanten durch geeignete Schweißverfahren dicht verbunden sind und eine kombinierte Gummi-Draht-Dichtungsschnur jeweils in die Nut der Frontplatte und der Rückwand eingelegt ist. Insgesamt ist das Gehäuse in seinem grundsätzlichen Aufbau wie die z.B. in der DE-AS 25 23 292, der DE-PS 25 38 314 und der DE-PS 24 43 122 beschriebene und unter dem Warenzeichen "SIDISET" bekanntgewordene Gehäusebaureihe ausgebildet, wobei für das vorliegende Gehäuse gegebenenfalls einzelne Teile, wie z.B. die Frontplatte und die Rückwand, aus dem bekannten System verwendet werden können. Die die Inneneinbauten, wie z.B. nicht dargestellte Leiterplatten, Steckbaugruppen oder Einschübe tragenden Mittelteile 3,4 sind jeweils von einer Profil-Trägerplatte aus einem Aluminium-Strangpreßprofil mit einem zu zwei einander gegenüberliegenden Plattenrändern, hier zur Front- und zur Rückseite parallelen Profilverlauf in Richtung der Gehäusebreite gebildet. Alle im Gehäusemantel 2 aufgenommenen Inneneinbauten sind über Führungs-, Rast- und Verdrahtungsmittel an den die Boden- und die Deckplatte 3 bzw. 4 bildenden, in besonderer Weise gestalteten Profil-Trägerplatten angeordnet, die hier also zusammen mit den genannten Mitteln die Montage- und Halterungseinrichtung für die Inneneinbauten bilden. Der Aufbau einer solchen Einrichtung ist im folgenden anhand der Fig. 2 beschrieben. Diese Figur zeigt ein Teilstück eines die Bodenplatte 3 bildenden, als Profil-Trägerplatte 1O ausgebildeten Mittelteiles 3. Das die Deckplatte 4 bildende Mittelteil ist - wie sich aus Fig. 1 ergibt - in gleicher Weise gestaltet und daher in Fig.2 nicht näher dargestellt. Die Einrichtung besteht im vorliegenden Fall also aus beiden Mittelteilen 3 und 4, d.h. aus zwei Profil-Trägerplatten 1O, die in gleicher Weise mit jeweils einer Rasterschiene 6 und mehreren, paarweise einander parallel gegenüberliegenden Führungsschienen 7 ausgebildet sind, so daß jeweils zwischen einer unteren und der senkrecht direkt darüber liegenden Führungsschiene z.B. eine Leiterplatte oder eine Steckbaugruppe in das Gehäuse 1 einschiebbar ist. Außerdem ist noch eine gemeinsame Verdrahtungsplatte 8 zur Verdrahtung der Leiterplatten oder Steckbaugruppen untereinander vorgesehen, wobei die Verdrahtungsplatte - wie auch die Leiterplatten oder Steckbaugruppen - mit einer Steckerleiste 9 ausgebildet ist.

Die einzelnen Komponenten der Einrichtung, nämlich die Profil-Trägerplatte 10, die Rasterschiene 6, die Führungsschienen 7 und die Verdrahtungsplatte 8 sind im einzelnen nun wie folgt gestaltet. Die Profil-Trägerplatte 10 hat einen regelmäßigen Profilverlauf mit gleichmäßig innerhalb des die Inneneinbauten aufnehmenden Bereiches verteilten Profilrippen 11 und Kühlrippen 12. Dabei sind auf der hier etwa 2 mm dicken Profil-Trägerplatte 10 fünf Profilrippen 11 vorgesehen, die in gleichem Abstand voneinander angeordnet sind und zu zwei einander parallel gegenüberliegenden Plattenrändern, also zur Front- und zur Rückseite, und zueinander parallel verlaufen. Zwischen jeweils zwei Profilrippen 11 sind vier Kühlrippen 12 vorgesehen, die in gleichem Abstand voneinander angeordnet sind und parallel zu den Profilrippen und zueinander verlaufen. Die Profilrippen 11 bestehen aus einem zur Ebene der Profil-Trägerplatte 10 senkrechten Steg 13 und einer auf diesem Steg liegend angeordneten C-Profilschiene 14 mit einer zu den Inneneinbauten hin offenen T-Nut 15, wobei die C-Profilschiene 14 über beide senkrechte Seiten des Steges hinausragt und hier symmetrisch in Bezug auf eine Symmetrielinie des Steges angeordnet ist. Dabei bildet der Steg der Profilrippen als Ständer oder Stütze für die die eigentliche Auflage für die Inneneinbauten bzw. deren Rast- und Führungsmittel übernehmende C-Profilschiene eine Art Wärmeableitsteg, während insbesondere durch die Form der Profilrippen und durch die zwischen den Profilrippen angeordneten Kühlrippen von der Höhe etwa des Steges vor allem die Oberfläche zur Wärmeabsorption vergrößert wird. Zudem wird dadurch eine hohe Formstabilität bei möglichst geringem Gewicht der Profil-Trägerplatte erreicht. Außerdem bietet die Form der C-Profilschiene 14 vielfältige variable Befestigungsmöglichkeiten für die Inneneinbauten bzw. deren Führungsmittel. Die Inneneinbauten können schraubenlos - falls erforderlich aber auch schraubbar mittels Gleit- oder Schiebemuttern - mit Hilfe der durch Einrasten oder Einschnappen in den C-Profilschienen 14 zu halternden Führungsschienen 7 an beliebigen Stellen der Profil-Trägerplatte befestigt werden. Damit bilden die C-Profilschienen gleichzeitig auch Montageschienen, welche die Anwendung einer Einschnapp-Montagetechnik für die Gehäuseeinbauten bzw. deren Führungs- und Rastmittel ermöglichen. Für den Einbau dieser Mittel ist die Profil-Trägerplatte 10 außerhalb des die Inneneinbauten aufnehmenden Bereiches zwischen den beiden äußersten Profilrippen 11 und dem jeweiligen Rand der Trägerplatte an der Front- bzw. an der Rückseite des Gehäuses noch mit einer zu den Inneneinbauten hin offenen Nut 16a bzw. 16b ausgebildet. Diese Nut ist einerseits durch die außenliegende, eine Hinterschneidung 17 bildende Schulter der entsprechenden C-Profilschiene 14 der äußersten Profilrippe 11 und andererseits durch eine hierzu gegenüberliegende Hinterschneidung 18 der Trägerplatte 10 T-förmig gestaltet und weist etwa in ihrer Mitte eine Rippe 19 auf, die gegenüber den Kühlrippen 12 etwas niedriger ist. Die nahe der Gehäusefrontseite befindliche Nut 16a dient zum Einsetzen der mit einem Teilungsraster ausgebildeten Rasterschiene 6, während in die nahe der Gehäuserückseite befindliche Nut 16b die gemeinsame Verdrahtungsplatte 8 senkrecht zur Trägerplatte und zur Einschubrichtung der Inneneinbauten stehend und gegebenenfalls an der C-Profilschiene 14 der anderen äußersten Profilrippe 11 anliegend eingesetzt ist. Die Rasterschiene 6 besteht aus einem im Querschnitt U-förmigen Kunststoffteil, dessen Schenkel 20 etwas nach außen gespreizt sind, so daß sie mit dem das Teilungsraster aufweisenden Mittelteil 21 einen Winkel von etwas mehr als 90° einschließen. Außerdem sind die Schenkel 20 der Rasterschiene 6 an ihrem freien Ende mit nach außen gerichteten Widerhaken 2 versehen. Damit ist die von oben her in die in ihrer Öffnung entsprechend dimensionierte Nut 16a einsetzbare und mit ihrer Länge der Gehäusebreite entsprechende Rasterschiene 6 unter Klemmung in der Nut fixierbar. Das Teilungsraster auf dem Mittelteil 21 der Rasterschiene 6 besteht aus einem Lochraster, das von einer Vielzahl von quer zur Nut 16a in Einschubrichtung der Inneneinbauten sich erstreckenden, langlochähnlichen Aussparungen 23 gebildet ist und z.B. durch Ziffern auf den zwischen den Aussparungen 23 stehenbleibenden Stegen 24 gekennzeichnet werden kann. Die Führungsschienen 7 sind an beiden Enden mit auf die Trägerplatte 10 zu gerichteten Zentrierhaken 25a bzw. 25b versehen und können mit dem Haken 25a an dem einen Ende in das Teilungsraster der Rasterschiene 6 und mit dem Haken 25b an dem anderen Ende in eine der im Teilungsraster der Rasterschiene angeordneten Aussparungen 26 der Verdrahtungsplatte 8 eingehängt werden. Dadurch wird im Zusammenwirken mit der in Fig.2 nicht dargestellten, in gleicher Weise ausgebildeten Deckplatte 4 des Gehäuses 1 gleichzeitig die schraubenlose Halterung der Verdrahtungsplatte 8 in der Nut 16b bewirkt. Die Aussparungen 26 der gemeinsamen Verdrahtungsplatte 8 sind dabei etwa in Höhe der Führungsschienen angeordnet und als Langlöcher ausgebildet, die sich mit ihrer Längsrichtung senkrecht zur Ebene der Trägerplatte erstrecken. Die schraubenlose Halterung der aus elastischem Kunststoff bestehenden Führungsschienen 7 erfolgt durch zwei an deren Unterseite, also an der der Trägerplatte 10 zugewandten Seite vorgesehene Einschnapphaken 27, welche aufgrund der vorteilhaften Ausbildung der C-Profilschienen 14 in diese einrasten. Zur Aufnahme von Inneneinbauten, z.B. zum Einschieben einer Leiterplatte, sind die Führungsschienen 7 mit einer Führungsrille 28 ausgebildet. Um die Leiterplatte dann möglichst spielfrei in dieser Führungsrille zu führen und zu halten, sind die Führungsschienen 7 im Verlauf ihrer Längserstreckung mit zwei Federarmen 29 ausgebildet, die an ihrem freien Ende eine in die Führungsrille ragende Nase 30 aufweisen. Die Federarme sind hier etwa 1/4 der Länge der Führungsschiene von deren Enden entfernt vorgesehen und so angeordnet, daß dadurch jeweils in einem über der Öffnung der T-Nut der beiden C-Profilschienen liegenden Bereich am freien Ende eines Federarmes, also neben der Nase 30, eine Aussparung 31 gebildet ist. Dadurch können hier zwei weitere Verdrahtungsplatten 8a und 8b in zwei zusätzlichen Zwischenebenen angebracht werden. Die zusätzlichen Verdrahtungsplatten 8a und 8b sind dann im in die Aussparungen und die darunterliegende T-Nut der C-Profilschienen eingesetzten Zustand durch die Aussparungen 31 zweier übereinanderliegender Führungsschienen 7 - wie in Fig. 1 gezeigt - in den Zwischenebenen gehalten. Außerdem sind die Führungsschienen 7 auch noch im Bereich beider Enden mit jeweils einem Federarm 32 mit Nase 33 am freien Ende ausgebildet. Dementsprechend ist die in die Führungsschiene einzuschiebende Leiterplatte dann an dem der Rasterschiene 6 benachbarten Ende mit einer Aussparung versehen, in welche die Nase 33 in vollständig in die Führungsschiene 7 eingeschobenem Zustand der Leiterplatte zu deren Fixierung in der Führungsrille 28 einrastet.

Für eine weitere Fixierung der Führungsschienen im Teilungsraster sind noch zwei entsprechend gezahnte Stützschienen 34 mit einer der Gehäusebreite entsprechenden Länge vorgesehen und im Verlauf der Längserstreckung der Führungsschienen im ersten und zweiten Drittel des Strangpreßprofils neben zwei C-Profilschienen von oben her in die Profilierung eingesetzt. Die Stützschienen 34 sind - wie auch die Rasterschienen 6 - durch Einpassen in der Länge zwischen den Gehäuseseitenwänden gegen seitliches Verschieben gesichert. Die auf Umschlag oben und unten, d.h. in den Boden- und in die Deckplatte 3 bzw. 4 einsetzbaren Führungsschienen 7 sind dazu an der den Stützschienen 34 zugekehrten Unterseite mit in die Zahnung 35 der Stützschienen eingreifenden, hier nicht sichtbaren Vorsprüngen ausgebildet.

Schließlich ist das gezeigte Einschnapp-Montagesystem auch kompatibel mit einer hier nicht dargestellten Metallführungsschiene von geeigneter entsprechender Gestaltung, die zwecks besserer Wärmeableitung von den Leiterplattenbaugruppen anstelle einer oder mehrerer Kunststoff-Führungsschienen an der Profil-Trägerplatte 10 angeordnet werden kann. Dabei können derartige Metallführungsschienen in den C-Profilschienen ohne weiteres mit üblichen Gleit- oder Schiebemuttern befestigt werden.

**Patentansprüche**

1. Einrichtung zur Montage und Halterung elektrischer Inneneinbauten, wie z.B. Leiterplatten, Steckbaugruppen oder Einschübe, mit einer Profil-Trägerplatte, die mit zu zwei einander parallel gegenüberliegenden Plattenrändern parallelen Nuten und Profilrippen für Führungsschienen und mindestens eine Rasterschiene der Inneneinbauten ausgebildet ist, insbesondere für Gehäuse elektrischer Geräte, **gekennzeichnet** durch die Kombination folgender Merkmale:

    a) Die Profilrippen (11) der Trägerplatte (10) sind in gleichem Abstand voneinander angeordnet und bestehen aus einem zur Plattenebene senkrechten Steg (13) und einer auf dem Steg liegend angeordneten, über beide senkrechte Seiten des Steges hinausragenden C-Profilschiene (14) mit einer zu den Inneneinbauten hin offenen T-Nut (15),

    b) außerhalb des die Inneneinbauten aufnehmenden Bereiches der Trägerplatte (10) ist zwischen den beiden äußersten Profilrippen (11) und dem jeweiligen Rand der Trägerplatte eine zu den Inneneinbauten hin offene T-Nut (16a, 16b) vorgesehen,

    c) in die eine am Plattenrand vorgesehene T-Nut (16a) ist eine mit einem Teilungsraster ausgebildete Rasterschiene (6) U-förmigen Querschnitts selbstklemmend eingesetzt,

    d) in die andere am gegenüberliegenden Plattenrand vorgesehene T-Nut (16b) ist senkrecht zur Plattenebene und zur Einschubrichtung der Inneneinbauten eine gemeinsame Verdrahtungsplatte (8) eingesetzt, die mit im Teilungsraster der Rasterschiene (6) angeordneten Aussparungen (26) ausgebildet ist,

    e) die aus elastischem Kunststoff bestehenden Führungsschienen (7) liegen auf den C-Profilschienen (14) auf und sind an ihrer der Trägerplatte (10) zugekehrten Unterseite mit mindestens zwei Einschnapphaken (27) ausgebildet und in die C-Profilschienen (14) eingerastet,

    f) die Führungsschienen (7) sind an beiden Enden jeweils mit einem in Richtung auf die Trägerplatte (10) gerichteten Zentrierhaken (25a, 25b) ausgebildet und damit in das Teilungsraster der Rasterschiene (6) bzw. in die Aussparungen (26) der gemeinsamen Verdrahtungsplatte (8) eingehängt, so daß dadurch die Führungsschienen (7) seitlich im Teilungsraster fixiert sind und die Verdrahtungsplatte (8) in der T-Nut (16b) gehalten ist.

2. Einrichtung nach Anspruch 1, **dadurch gekennzeichnet,** daß die Schenkel (20) der U-förmigen Rasterschiene (6) etwas nach außen gespreizt sind, so daß sie mit dem das Teilungsraster aufweisenden Mittelteil (21) einen Winkel von etwas mehr als 90° einschließen.

3. Einrichtung nach Anspruch 1 oder 2, **dadurch gekennzeichnet,** daß mindestens ein Schenkel (20) der U-förmigen Rasterschiene (6) an seinem freien Ende mit einem nach außen gerichteten Widerhaken (22) ausgebildet ist.

4. Einrichtung nach einem der Ansprüche 1 bis 3, **dadurch gekennzeichnet,** daß das Teilungsraster der Rasterschiene (6) ein Lochraster ist und die Löcher als in Einschubrichtung der Inneneinbauten sich erstreckende Langlöcher (23) ausgebildet sind.

5. Einrichtung nach einem der vorhergehenden Ansprüche, **dadurch gekennzeichnet,** daß die Führungsschienen (7) im Bereich beider Enden mit jeweils einem Federarm (32) und im Verlauf ihrer Längserstreckung mit weiteren Federarmen (29) ausgebildet sind, und daß die Federarme (32,29) an ihrem freien Ende eine in die Führungsrille (28) der Führungsschiene (7) ragende Nase (33 bzw. 30) aufweisen.

6. Einrichtung nach Anspruch 5, **dadurch gekennzeichnet,** daß die im Verlauf der Längserstreckung der Führungsschienen (7) vorge-

sehenen Federarme (29) so angeordnet sind, daß dadurch jeweils in einem über der Öffnung der T-Nut (15) einer C-Profilschiene (14) liegenden Bereich amfreien Ende eines Federarmes (29) eine Aussparung (31) der Führungsschiene (7) gebildet ist, in die jeweils eine weitere Verdrahtungsplatte (8a bzw. 8b) in einer Zwischenebene einsetzbar ist.

7. Einrichtung nach Anspruch 5 oder 6, **dadurch gekennzeichnet,** daß die Inneneinbauten mit einer Ausnehmung für die Nase (33) eines endseitigen Federarmes (32) der Führungsschiene (7) ausgebildet sind.

8. Einrichtung nach einem der vorhergehenden Ansprüche, **dadurch gekennzeichnet,** daß die Aussparungen (26) der gemeinsamen Verdrahtungsplatte (8) als Langlöcher ausgebildet sind, die sich mit ihrer Längsrichtung senkrecht zur Ebene der Trägerplatte (1O) erstrecken.

9. Einrichtung nach einem der vorhergehenden Ansprüche, **dadurch gekennzeichnet,** daß zwischen den beiden äußersten PRofilrippen (11) der Trägerplatte (1O) im Teilungsraster gezahnte Stützschienen (34) vorgesehen und seitlich von Profilrippen (11) in die Profilierung der Trägerplatte (1O) eingesetzt sind.

1O. Einrichtung nach Anspruch 9, **dadurch gekennzeichnet,** daß die Führungsschienen (7) an der den Stützschienen (34) zugekehrten Unterseite mit in die Zahnung (35) der Stützschienen eingreifenden Vorsprüngen ausgebildet sind.

11. Einrichtung nach Anspruch 1O, **dadurch gekennzeichnet,** daß sich die Stützschienen (34) und die Rasterschiene (6) mit ihrer Länge über die volle Länge der Profilierung der Trägerplatte (1O) erstrecken.

12. Einrichtung nach einem der vorhergehenden Ansprüche, **dadurch gekennzeichnet,** daß die T-Nuten (16a,16b) an den Plattenrändern durch die außenliegende, eine Hinterschneidung (17) bildende Schulter der C-Profilschiene (14) der äußersten Profilrippen (11) und durch eine hierzu gegenüberliegende Hinterschneidung (18) der Trägerplatte (1O) gebildet sind.

13. Einrichtung nach einem der vorhergehenden Ansprüche, **dadurch gekennzeichnet,** daß zwischen den Profilrippen (11) zu diesen und zueinander parallele Kühlrippen (12) mit einer etwa der Höhe des Steges (13) der Profilrippen entsprechenden Höhe vorgesehen sind.

14. Einrichtung nach Anspruch 13, **dadurch gekennzeichnet,** daß die Trägerplatte (1O) mit fünf Profilrippen (11) und zwischen jeweils zwei Profilrippen mit vier in gleichem Abstand voneinander angeordneten Kühlrippen (12) ausgebildet ist.

## Revendications

1. Dispositif pour le montage et le support d'éléments électriques incorporés, comme par exemple des cartes à circuits imprimés, des sous-ensembles embrochables ou des tiroirs, comprenant une plaque-support profilée pourvue de rainures et de nervures profilées parallèles à deux bords opposés, parallèles entre eux, pour des glissières et au moins un rail-échelle dont les divisions correspondent aux pas d'une grille de base pour les éléments incorporés, en particulier pour enceintes d'appareils électriques, caractérisé par la combinaison des moyens particuliers suivants:

a) les nervures profilées (11) de la plaque-support (10) sont disposées à la même distance les unes des autres et sont formées d'une âme (13) perpendiculaire au plan de la plaque et d'un rail profilé en C (14) présentant une rainure en T (15) ouverte vers les éléments incorporés, qui est disposé longitudinalement sur l'âme et déborde celle-ci des deux côtés perpendiculaires,

b) une rainure en T (16a, 16b), ouverte vers les éléments incorporés, est prévue à l'intérieur de la zone de la plaque-support (10) recevant les éléments intérieurs, entre chacune des deux nervures profilées (11) situées le plus à l'extérieur et le bord voisin de la plaque-support,

c) un rail-échelle (6), de section droite en U, est monté à blocage automatique dans une rainure en T (16a) prévue sur un bord de la plaque, rail qui présente une échelle dont les divisions correspondent aux pas d'une grille de base,

d) un panneau de câblage (8) commun est monté dans l'autre rainure en T (16b), prévue sur le bord opposé de la plaque, panneau qui est perpendiculaire au plan de la plaque et à la direction d'introduction des éléments incorporés et est pourvu d'évidements (26) correspondant à l'échelle du rail (6),

e) les glissières (7), faites d'une matière plastique élastique, reposent sur les rails profilés en C (14) et sont munies, sur leur côté inférieur dirigé vers la plaque support (10) d'au moins deux crochets d'encliquetage (27), par lesquels les glissières sont encliquetées dans les rails en C (14),

f) les glissières (7) sont munies de crochets de centrage (25a, 25b), un à chacune de leurs deux extrémités, dirigés vers la plaque-support (10) et par lesquels les glissières sont suspendues dans l'échelle du rail (6) d'un côté et dans les évidements (26) du panneau de câblage (8) commun de l'autre côté, de sorte que les glissières (7) sont ainsi fixées latéralement suivant la grille de base et que le panneau de câblage (8) est maintenu dans la rainure en T (16b).

2. Dispositif selon la revendication 1, caractérisé en ce que les ailes (20) du rail-échelle (6) en U sont écartées légèrement vers l'extérieur, de sorte qu'elles forment un angle légèrement supérieur à 90° avec la partie centrale (21) du rail, présentant l'échelle.

3. Dispositif selon la revendication 1 ou 2, caractérisé en ce que l'une au moins des ailes (20) du rail échelle (6) en U est pourvue d'un rebord (22) dirigé vers l'extérieur à son extrémité libre.

4. Dispositif selon une des revendications 1 à 3, caractérisé en ce que l'échelle du rail (6) est formée par une perforation régulière dont les perforations sont réalisées sous forme de trous oblongs (23) s'étendant dans le sens de l'introduction des éléments intérieurs.

5. Dispositif selon une des revendications précédentes, caractérisé en ce que les glissières (7) sont pourvues d'un bras élastique (32) dans la région de chacune de leurs deux extrémités, ainsi que de bras élastiques supplémentaires (29) sur leur étendue longitudinale et que les bras élastiques (32, 29) portent à leur extrémité libre un tenon (33 ou 30) pénétrant dans la cannelure de guidage (28) de la glissière (7).

6. Dispositif selon la revendication 5, caractérisé en ce que les bras élastiques (29) prévus sur l'étendue longitudinale des glissières (7) sont disposés de manière qu'ils forment chacun, dans une partie située au-dessus de l'ouverture de la rainure en T (15) d'un rail en C (14), à l'extrémité libre du bras élastique (29), un évidement (31) de la glissière (7), évidement dans lequel peut être disposé dans un plan intermédiaire, un panneau de câblage (8a ou 8b) supplémentaire.

7. Dispositif selon la revendication 5 ou 6, caractérisé en ce que les éléments incorporés sont pourvus d'un évidement pour le tenon (33) d'un bras élastique (32) extrême de la glissière (7).

8. Dispositif selon une des revendications précédentes, caractérisé en ce que les évidements (26) du panneau de câblage (8) commun sont réalisés comme des trous oblongs dont l'étendue longitudinale est perpendiculaire au plan de la plaque support (10).

9. Dispositif selon une des revendications précédentes, caractérisé en ce que des rails d'appui (34), crantés suivant la grille de base, sont prévus entre les deux nervures profilées (11) extérieures de la plaque-support (10) et sont montés à côté de nervures profilées (11) dans le profilage de la plaque support (10).

10. Dispositif selon la revendication 9, caractérisé en ce que les glissières (7) sont pourvues de saillies sur le côté inférieur dirigé vers les rails d'appui (34), saillies qui pénètrent dans le crantage (35) des rails d'appui.

11. Dispositif selon la revendication 10, caractérisé en ce que les rails d'appui (34) et le rail échelle (6) s'étendent longitudinalement sur toute la longueur du profilage de la plaque-support (10).

12. Dispositif selon une des revendications précédentes, caractérisé en ce que les rainures en T (16a, 16b) sur les bords de la plaque, sont formées par un épaulement extérieur, définissant un rentrant (17), du rail en C (14) des nervures profilées extérieures (11) d'une part et par un rentrant (18) opposé de la plaque-support (10) d'autre part.

13. Dispositif selon une des revendications précédentes, caractérisé en ce que des ailettes de refroidissement (12) dont la hauteur correspond à peu près à la hauteur de l'âme (13) des nervures profilées, sont prévues entre les nervures profilées (11), parallèlement à celles-ci et entre elles.

14. Dispositif selon la revendication 13, caractérisé en ce que la plaque-support (10) est dotée de cinq nervures profilées (11) et, entre chaque paire de nervures profilées voisines, de quatre ailettes de refroidissement (12) uniformément espacées.

**Claims**

1. Device for mounting and supporting electrical interior constructions such as, for example, circuit boards, plug-in assemblies or modules, comprising a shaped support plate which is constructed with two plate edges which are parallel and opposite to one another, parallel grooves and shaped ribs for guide rails and at least one spacing rail of the interior constructions, particularly for housings of electric devices, characterized by the combination of the following features:

a) the shaped ribs (11) of the support plate (10) are arranged at equal distance from one another and consist of a web (13) which is vertical to the plane of the plate and a C-section rail (14), which is arranged to rest on the web and which protrudes past the two vertical sides of the web, with a T-groove (15) which is open towards the interior constructions,

b) outside the area of the support plate (10) accommodating the interior constructions, a T-groove (16a, 16b), which is open towards the interior constructions, is provided between the two outermost shaped ribs (11) and the respective edge of the support plate,

c) a spacing rail (6) of U-shaped cross-section and constructed with a spacing pattern is inserted in a self-clamping manner into one T-groove (16a) provided at the plate edge,

d) a common wiring plate (8), which is constructed with recesses (26) arranged in the spacing pattern of the spacing rail (6) is inserted vertically to the plane of the plate and to the direction of insertion of the interior constructions into the other T-groove (16b) provided at the opposite plate edge,

e) the guide rails (7) consisting of flexible plastic rest on the C-section rails (14) and are constructed at their underside facing the support plate (10) with at least two snap-in hooks (27) and locked into the C-section rails (14),

f) the guide rails (7) are constructed at both ends in each case with a centring hook (25a, 25b) which is directed in the direction of the support plate (10) and are thus hooked into the spacing pattern of the spacing rail (6) or into the recesses (26) of the common wiring plate (8) in such a manner that by this means the guide rails (7) are laterally fixed in the spacing pattern and the wiring plate (8) is held in the T-groove (16b).

2. Device according to Claim 1, characterized in that the legs (20) of the U-shaped spacing rail (6) are spread slightly outward so that they enclose an angle of slightly more than 90° with the centre part (21) exhibiting the spacing pattern.

3. Device according to Claim 1 or 2, characterized in that at least one leg (20) of the U-shaped spacing rail (6) is constructed with an outwardly directed barb (22) at its free end.

4. Device according to one of Claims 1 to 3, characterized in that the spacing pattern of the spacing rail (6) is a hole pattern and the holes are constructed as elongated holes (23) extending in the direction of insertion of the interior constructions.

5. Device according to one of the preceding Claims, characterized in that the guide rails (7) are constructed with one spring arm (32) in each case in the area of both ends and with further spring arms (29) in the course of their longitudinal extent, and that the spring arms (32, 29) exhibit at their free end a nose (33 and 30, respectively) which projects into the guide groove (28) of the guide rail (7).

6. Device according to Claim 5, characterized in that the spring arms (29) provided in the course of the longitudinal extent of the guide rails (7) are arranged in such a manner that by this means a recess (31) in the guide rail (7) is in each case formed in an area located above the opening of the T-groove (15) of a C-section rail (14) at the free end of a spring ann (29), into which recess in each case a further wiring plate (8a or 8b) can be inserted in an intermediate plane.

7. Device according to Claim 5 or 6, characterized in that the interior constructions are constructed with a recess for the nose (33) of an end-side spring arm (32) of the guide rail (7).

8. Device according to one of the preceding Claims, characterized in that the recesses (26) of the common wiring plate (8) are constructed as elongated holes, the longitudinal direction of which extends vertically to the plane of the support plate (10).

9. Device according to one of the preceding Claims, characterized in that support rails (34) which are toothed in the spacing pattern are provided between the two outermost shaped ribs (11) of the support plate (10) and are inserted into the moulding of the support plate (10) to the side of shaped ribs (11).

10. Device according to Claim 9, characterized in that the guide rails (7) are constructed at the underside facing the support rails (34) with projections engaging the toothing (35) of the support rails.

11. Device according to Claim 10, characterized in that the support rails (34) and the spacing rail (6) extend with their length over the full length of the moulding of the support plate (10).

12. Device according to one of the preceding Claims, characterized in that the T-grooves (16a, 16b) at the plate edges are formed by the outside shoulder, forming an undercutting (17), of the C-section rail (14) of the outermost shaped ribs (11) and by an undercutting (18), which is opposite thereto, of the support plate (10).

13. Device according to one of the preceding Claims, characterized in that between the shaped ribs (11), cooling ribs (12) which are parallel to these and to one another, are provided with a height which approximately corresponds to the height of the web (13, of the shaped ribs.

14. Device according to Claim 13, characterized in that the support plate (10) is constructed with five shaped ribs (11) and between two shaped ribs in each case with four cooling ribs (12) which are arranged at equal distance from one another.

# FIG 1

# FIG 2